# EUROPÄISCHE PATENTSCHRIFT

(11) **EP 2 050 837 B1**
(45) Veröffentlichungstag und Bekanntmachung des Hinweises auf die Patenterteilung: **14.12.2011**
(21) Anmeldenummer: 06847390.9
(22) Anmeldetag: 26.07.2006
(51) Int. Cl.: C23C 14/35, C23C 28/00, C23C 14/56

(54) **VERFAHREN ZUR IONENPLASMAAPPLIKATION VON FILMBESCHICHTUNGEN UND VORRICHTUNG ZUR DURCHFÜHRUNG DES VERFAHRENS**
METHOD FOR ION-PLASMA APPLICATION OF FILM COATINGS AND A DEVICE FOR CARRYING OUT SAID METHOD
PROCÉDÉ D'APPLICATION À PLASMA D'IONS DE REVÊTEMENTS DE FILM À COMPOSANTS MULTIPLES ET INSTALLATION CORRESPONDANTE

(43) Veröffentlichungstag der Anmeldung: 22.04.2009
(73) Patentinhaber: Naco Technologies, SIA, Riga 1079 (LV)
(72) Erfinder: Spivakov, Dmitry Davidovich, Moscow 124460 (RU); Mitin, Valery Semenovich, Moscow 127322 (RU)
(74) Vertreter: Anohins, Vladimirs
(86) Internationale Anmeldenummer: PCT/RU2006/000399
(87) Internationale Veröffentlichungsnummer: WO 2008/013469

(56) Entgegenhaltungen:
- WO-A2-2005/110698
- JP-A- 2000 129 438
- JP-A- 2006 096 841
- RU-C1- 2 063 472
- US-A- 5 556 519
- YANG SHICAI ET AL: "Applications of Cr-based metal nitride hard coatings using multi-magnetron sputtering sources and elemental metal targets" CAILIAO RECHULI XUEBAO = TRANSACTIONS OF MATERIALS AND HEATTREATMENT, CAILIAO RECHULI XUEBAO, CN, vol. 25, no. 5, 1 October 2004 (2004-10-01), pages 821-826, XP009093174 ISSN: 1009-6264

## Beschreibung

Die Erfindung bezieht sich auf eine Vorrichtung nach dem Oberbegriff des Anspruchs 1 und ein Verfahren zur Anwendung der Vorrichtung.

Die Erfindung betrifft eine Vorrichtung mit Einrichtungen zur Herstellung von verschiedenen Deckschichten durch lon-Plasma-Zerstäubung, wobei die Materialien in atomarer oder ionischer Form als Dampfphase auf die Substratoberfläche durch elektrische Entladung abgeschieden werden. Die Erfindung kann in der Elektronik, der Elektrotechnik, der Atomindustrie, der Optik und anderen Industriezweigen angewandt werden.

Die Entwicklung der Wissenschaft, der Technologien und der Technik ist mit der Herstellung von Materialien verbunden, deren Einsatz ein grundsätzlich neues Niveau der funktionellen Charakteristiken der Erzeugnisse ermöglicht. Oft werden diese Charakteristiken durch die Eigenschaften der Arbeitsoberfläche der Erzeugnisse bestimmt, die durch die Beschichtung mit Schichten mit vorgegebener Zusammensetzung und vorgegebenen Eigenschaften gebildet werden.

Ein bekanntes Verfahren zur Beschichtung beruht auf der Zerstäubung des Materials durch elektrische Entladung im Gas unter Niederdruck und dem Abscheiden von Atomen oder Ionen dieses Materials auf dem Substrat mit Bildung der Deckschicht. Es ist allgemein bekannt, dass die Zerstäubungseffektivität durch ein Magnetfeld wesentlich erhöht werden kann, das das elektrische Feld durchkreuzt und eine Haftstelle für die bei der Ionisation erzeugten Elektronen bildet. Durch die Anwendung der Magnetronzerstäubung kann man die Geschwindigkeit der Targetzerstäubung und des Abscheidens des Materials auf dem Substrat um eine Größenordnung erhöhen. Außerdem kann der Prozess unter einem nicht so niedrigen Gasdruck und beim intensiven lonenbeschuss des Substrats durchgeführt werden. Dadurch wird die Adhäsion und die Schichtstruktur verbessert.

Das Verfahren zur Ion-Plasma-Magnetronzerstäubung des Targets und einer Beschichtung verschiedener Erzeugnisse ist also ein höchsteffektiver Prozess für das Aufbringen von Dünnschichten. Dieses Verfahren erlaubt es, mit relativ niedrigem Aufwand verschiedene homogene Schichten zu erhalten, die mit dem Substrat fest verbunden und damit auf molekularem Niveau gebunden sind. Zurzeit wird diese Technologie in der Forschung und der industriellen Entwicklung zur Herstellung einer neuen Generation von leichten und dauerhaften Erzeugnissen breit angewandt.

Der heutige Entwicklungsstand des Ion-Plasma-Magnetronverfahrens erlaubt es aber nicht, seine Anwendungsgebiete für die Herstellung auf viele Erzeugnisgruppen zu erweitern, die in verschiedenen technischen Gebieten angewandt werden. Diese Einschränkungen sind verursacht durch:
1) relativ niedrige Beschichtungsgeschwindigkeiten (bis zu 5 µm/Std);
2) mangelhaftem lonenaktivierungsgrad und Schwächung der Adhäsion bei einer Schichtdicke ab 5 µm;
3) Schwierigkeiten bei der gemeinsamen Beschichtung mit Materialien, deren Beschichtungskoeffiziente sich wesentlich unterscheiden;
4) und hohe Anforderungen an die Sustratoberflächengüte (Oberflächenrauheit soll nicht höher als 0,2 - 0,3 µm sein).

Die erwähnten Einschränkungen sind damit verbunden, dass in den bekannten Vorrichtungen es unmöglich ist, die Dichte der Entladungsleistung höher als 40 W pro 1 cm² der Oberfläche des Magnetrons im Bereich seiner Höchsterosion zu erreichen. Bei solchen relativ nicht hohen spezifischen Leistungen wird die Zerstäubungsintensität jeder Beschichtungskomponente in bedeutendem Maße durch ihren Zerstäubungskoeffizient bestimmt. Außerdem ist das Massenverhältnis der Beschichtungskomponenten in der Dampfphase praktisch nicht regelbar. Deshalb entstehen bei der Anwendung des Verfahrens zur Beschichtung mit zusammengesetzten Schichten beträchtliche technologische Probleme, die die Anwendungsmöglichkeiten wesentlich begrenzen. Fällt es schwer, die Materialien der Beschichtungskomponenten zu einem Target von gegebener Form (Platte, Buchse oder Rohr) zusammenzuschmelzen oder zusammenzupressen, ist eine separate Zerstäubung der Komponenten (zum Beispiel mittels Mosaiktargete) durchzuführen. So werden zum Beispiel Deckschichten aus Kohlenstoff und Metall hergestellt, wobei eine separate Zerstäubung der Graphit- und Chromtargete (s. Patent GB 2258343, C 23 C 14/34, 1997) durchgeführt wird. Dabei sind in jedem spezifischen Fall komplizierte Aufgaben für die Berechnung der Targetgeometrien, die Abstimmung der Zerstäubungsgeschwindigkeiten jeder der Komponenten und der technologischen Parameter des Zerstäubungsprozesses zu lösen. Die homogene Agitation von atomaren Dampfströmen der zu zerstäubenden Komponenten sowie die gleichmäßige Abscheidung der Komponenten auf dem Substrat als Schicht mit vorgegebener Zusammensetzung sind weitere Probleme. Ein weiterer Nachteil der separaten Zerstäubung der Targete besteht darin, dass es kompliziert ist mittels dieses Verfahrens Schichten aus drei und mehr Komponenten herzustellen. Dies insbesondere wenn sich die Zerstäubungskoeffiziente dieser Targetsmaterialien wesentlich unterscheiden und stark von den Prozessparametem (solchen wie Arbeitsdruck, Temperatur, magnetische Permeabilität, Entladungsstrom und -spannung) abhängen. Bei einem bekannten Verfahren zur Beschichtung in einer Magnetronvorrichtung mit einem auf der Kathode angeordneten Mosaik-Scheibentarget und einer Flachanode für die Halterung der Substrate (s. Patentanmeldung JP 61-54112, C 23 C 14/36, 1986) ist die Lösung des Problems des Komponentenverhältnisses in der Schicht vorgeschlagen. Erfindungsgemäß ist unter der Kathode ein Magnet angeordnet, der das dem elektrischen Feld zwischen den Elektroden orthogonal verlaufende Magnetfeld erzeugt. Außerhalb der Vakuumkammer, im Bereich der Ebene der Arbeitsoberfläche der Kathode sind die Generatorwicklungen für die Erzeugung des dem elektrischen Feld zwischen den Elektroden parallel verlaufenden Magnetfeldes angeordnet. Im Laufe der Beschichtung wird die Magnetfeldstärke geändert, wodurch die Zone der Höchsteinwirkung des Plasmas auf das Mosaiktarget auf dem oder jenem Targetelement konzentriert wird. Dies erlaubt, die Zerstäubungsintensität jeder Targetkomponente sowie ihren Gehalt in der Beschichtung zu regeln. Das Verfahren erlaubt es, zusätzliche Mittel zur Prozesssteuerung zu erhalten und Schichten mit variabler Zusammensetzung insbesondere bei Verwendung der Mosaiktargete herzustellen. Der Nachteil dieses Verfahrens ist eine relativ niedrige Geschwindigkeit der Targetzerstäubung und dementsprechend eine niedrige Leistungsfähigkeit bei der Herstellung von Erzeugnissen mit relativ dicken Schichten.

Es ist ein Vefahren zur Ion-Plasma-Abscheidung von Mehrkomponentenfilmschichten mit der Anwendung eines geschlossenen Magnetfeldes sowie die Vorrichtung für dessen Ausführung bekannt, die von der Firma Teer Coatings LTD (s. USA Patent No 5 556 519) hergestellt ist. Bei diesem Verfahren werden Magnetrone angewandt, die in Form von Außen- und Innenpolen ausgeführt sind, die gegenläufig gerichtet sind. Dabei ist wenigstens ein Magnetron unausgeglichen und die Machbarmagnetrone sind vorwiegend mit gegengepolten Außenpolen so angeordnet, dass die Abscheidungszone, in der das Substrat angeordnet ist, vorwiegend von den geschlossenen Linien des Magnetfeldes umgeben ist. Das Magnetfeld ist von den Au-ßenpolen der Nachbarmagnetrone erzeugt. Dabei ist das Substrat elektrisch verschoben und als Kathode ausgebildet, um die Ionen mit einer Positivladung anzuziehen.

Nach einer Variante zur Ausführung der Erfindung nach dem Patent USA No 5 556 519 enthält die Vorrichtung zur Ausführung der Erfindung eine geerdete Kammer, eine in der Kammer angeordnete Anodenvorrichtung, Einrichtungen zur Erzeugung des elektrischen Feldes; die in der Mitte der Kammer angeordneten Einrichtungen zur Befestigung des Substrats, das durch die erwähnten elektrischen Einrichtungen zur Anziehung der Ionen an das Substrat elektrisch verschoben ist, Einrichtungen zur Erzeugung des Magnetfeldes, die mindestens zwei Magnetrone enthalten, wenigstens das eine von denen unausgeglichen ist, jedes Magnetron weist gegenläufig gerichteten Außen- und Innenringmagnetpole auf, wobei der Außenpol wenigstens des einen Magnetrons und der Außenpol seines Nachbarmagnetrons gegengepolt sind und das Magnetfeld zur Verhinderung eines wesentlichen Elektronenverlusts in der Zone zwischen den Magnetronen schliessen; die Innen- und Außenpole der Magnetrione weisen ein hohes elektrisches Potential der erwähnten geerdeten Kammer gegenüber auf, wodurch die Dichte des auf das Substrat abgeschiedenen Ionenstromes erhöht wird.

Ein bekanntes Verfahren und Gerät, die der vorliegenden Erfindung am nächsten stehen, ermöglichen es, die Effektivität der Ionisierung, der Zerstäubung der Targetsmaterialien und des Abscheidens dieser Materialien auf das Substrat wesentlich zu erhöhen. Beim Abscheiden zusammengesetzter Schichten aber, die aus den Materialien bestehen, deren Zerstäubungskoeffiziente sich wesentlich unterscheiden, (insbesondere bei Anwendung von Mosaiktargete) erlauben das bekannte Verfahren und das Gerät zu dessen Ausführung nicht, eine hohe Produktivität des Prozesses beim Abscheiden von relativ dicken Schichten zu erreichen. Das ist damit zu erklären, daß es beim bekannten Verfahren schwierig ist, die hohe Entladungsleistungsdichte (höher als 40 W/cm² des Magnetrons) wegen der Plamadekonzentration in der Nähe der Kathode mit unausgeglichenem Magnetfeld zu erreichen.

Bei relativ nicht hohen spezifischen Leistungen entstehen die erwähnten technologischen Einschränkungen, die die funktionellen Mögligkeiten der Technologie bei der Herstellung der Erzeugnisse für verschiedene Gebrauchszwecke beeinträchtigen. Deshalb kann das bekannte Verfahren beim Abscheiden von zusammengesetzten und relativ dicken Schichten nicht immer effektiv eingesetzt werden. So gelingt es nicht, beim Beschichten von Materialien mit niedriger elektrischer Leitfähigkeit oder der Dielektriken (z. B. Keramik oder Glas) die ausreichende Oberflächenaktivierung zu erreichen. In diesem Fall ist die Oberfläche mit einem unabhängigen Ionenstrahl zu beschiessen oder ein Hochfrequenzpotential an das Substrat anzulegen.

Zweck der Erfindung ist, die bekannte Vorrichtung zu vervollkommnen, um die Leistungsfähigkeit und die Anwendbarkeit des Prozesses zum Abscheiden von Mehrkomponentenfilmschichten verschiedener Zusammensetzung und erhöhter Dicke bei Verwendung von Mosaiktargete zu erhöhen.

Die zu lösende technische Aufgabe besteht in der Auswahl von optimalen Parametern des Beschichtungsprozesses zwecks Steigerung der Nutzionisierungsintensität sowie eine Vorrichtung zu schaffen, die es ermöglicht, im eingeschwungenen Betriebszustand, bei hoher Zerstäubungsgeschwindigkeit die Mehrkomponentenfilmschichten vorgegebener Zusammensetzung aus Mosaiktargeten abzuscheiden.

Die gestellte Aufgabe wird durch die Merkmale des Anspruchs 1.

Die Vorrichtung weist auf:
- eine geerdete Kammer und eine in der Kammer angeordnete Anodenvorrichtung;
- Mittel zur Erzeugung des elektrischen Feldes;
- eine in der Mitte der Kammer angeordnete Planeten-Karusselleinrichtung zur Befestigung der zu beschichtenden Erzeugnisse, die durch die erwähnten elektrischen Mittel zur Anziehung der Ionen an die Erzeugnisse elektrisch verschoben ist;
- ein System zur Erzeugung des Magnetfeldes, das zwei gegenüber einander angeordnete unausgeglichene Magnetrone enthält, wobei jedes unausgeglichene Magnetron die gegenläufig gerichteten Außen- und Innenringmagnetpole aufweist und wobei der Außenpol des einen Magnetrons und der Außenpol des anderen Magnetrons gegengepott sind;
- mindestens zwei ausgeglichene gekühlte Hochgeschwindigkeitsmagnetrone, jedes ausgeglichene Magnetron weist gegenläufig gerichtete Außen- und Innenringmagnetpole auf, wobei der Außenpol des einen Magnetrons und der Außenpol des anderen Magnetrons gegengepolt sind;
- in den Zwischenräumen zwischen zwei Paaren der unausgeglichenen und ausgeglichenen Magnetrone, die sich zwischen ihren gleichgepolten Außenringmagnetpolen befinden, sind zwei gegenüber einander installierte Ionenquellen mit Kaltkathode angeordnet, die als gegenläufig gerichtete Innen- und Außenringmagnetpole ausgeführt sind, wobei der Außenpol jeder Ionenquelle und die Außenpole der nächstliegenden unausgeglichenen und ausgeglichenen Magnetrone gegengepolt sind
   und
- in zwei anderen Zwischenräumen zwischen zwei Paaren der unausgeglichenen und ausgeglichenen Magnetrone, die sich zwischen ihren gegengepolten Auβenringmagnetpolen befinden, sind zwei gegenüber einander installierte Lichtbogen-Metallionenquellen mit Stabilisierungsspulen angeordnet.

Nach einer besonderen Ausführungsform der Vorrichtung ist in der Mitte der Kammer eine Einrichtung zur Erhitzung der Erzeugnisse angeordnet.

Nach einer anderen besonderen Ausführungsform der Vorrichtung sind die Gehäuse der ausgeglichenen Magnetrone mit 50 bis 85 mm breiten Innenhohlräumen zur Abkühlung ausgestattet, wo die Magnetpole angeordnet sind. Zwischen dem Zentral- und Außenpol des Magnetrons ist ein Kanal zum Kühlmitteldurchfluss in Form eines Spalts zwischen dem Target und der Stirnseite des Distanzstücks zwischen den Magnetronpolen gebildet. Die Breite des Spalts entspricht der Distanz zwischen den Polen und beträgt 10 bis 20 mm. Die Höhe des Spalts entspricht der Distanz zwischen der Oberfläche des Distanzstücks und der Kühlfläche des Targets und beträgt 4 bis 6 mm.

Die Vorrichtung nach Anspruch 1 wird angewandt und zur Beschichtung mit folgenden Operationen eingesetzt
- Vorbereitung der unausgeglichenen Magnetrone mit homogenen Targeten,
- Vorbereitung der unausgeglichenen Magnetrone mit Mosaiktargeten, Anordnung der Erzeugnisse in der Planeten-Karusselleinrichtung,
- Vorbereitung der Vorrichtung zur Arbeit, Ionenätzung und Aktivierung der Erzeugnisse mittels der unausgeglichenen Magnetrone bei einer Dichte der Entladungsleistung von 5 bis 40 W/cm²,
- Nachaktivierung der Erzeugnisse mittels einer der Gasione (z. B. einer Argonione erzeugenden Ionenquelle bei der Beschleunigungsspannung bis 5000 V) oder Aktivierung und Sättigung der Oberflächenschicht mit Metall oder Gas mittels einer die Metall- oder Gasione (z. B. Stickstoffione) erzeugenden Lichtbogenquelle bei der Verschiebungsspannung am Erzeugnis von 1700 V,
- Erhitzung der Erzeugnisse durch einen Erhitzer bis zu einer Temperatur von 250 bis 1200 °C,
- Abscheiden der Primärschicht mittels der unausgeglichenen Magnetrone bei der Dichte der Entladungsleistung von 5 bis 40 W/cm²,
- Abscheiden der Sekundärschichten bis 10 µm Dicke durch gleichzeitige Anwendung der unausgeglichenen Magnetrone bei der Dichte der Entladungsleistung von 5 bis 40 W/cm² und der ausgeglichenen Magnetrone bei einer Dichte der Entladungsleistung von 40 bis 500 W/cm² und einer remanenten Induktion des Magnetfeldes von 0,03 T bis 0,1 T,
- Abscheiden der Hauptschicht durch gleichzeitige Anwendung der unausgeglichenen Magnetrone bei einer Dichte der Entladungsleistung von 5 bis 40 W/cm² und der ausgeglichenen Magnetrone bei einer Dichte der Entladungsleistung von 40 bis 500 W/cm² und der remanenten Induktion des Magnetfeldes von 0,03 T bis 0,1 T,
- Abscheiden der Hauptschicht mit Mehrschicht-Nanokristallstruktur durch gleichzeitige Anwendung der unausgeglichenen Magnetrone bei einer Dichte der Entladungsleistung von 5 bis 40 W/cm² und der ausgeglichenen Magnetrone bei der Dichte der Entladungsleistung von 40 bis 500 W/cm² und der remanenten Induktion des Magnetfeldes von 0,03 T bis 0,1 T, sowie der Lichtbogenquellen mit einem Lichtbogenstrom von 40 bis 160A und einer Spannung von 40 bis 80V.

Nach einer anderen Ausführungsform der Vorrichtung werden die Erzeugnisse zuerst bis zu einer Temperatur von 250 bis 1200 °C erhitzt, dann wird die Oberfläche der Erzeugnisse bis zu einer Temperatur 1500 °C durch Nachbeschuss mit Metall- und/oder Gasionen nacherhitzt. Die Ionen werden mittels Lichtbogenquellen bei der Verschiebungsspannung am Erzeugnis von 1700 V erzeugt.

Gemäß der Erfindung ist also ein Magnetronzerstäubungssystem zum lonenabscheiden der Schichten entwickelt, in dem ein Paar von ausgeglichenen gekühlten Hochgeschwindigkeitsmagnetronen mit homogenen Targeten verwendet ist. Dabei weisen die ausgeglichenen Magnetrone solche technologischen Parameter (die Dichte der Entladungsleistung von 40 bis 500 W/cm² und die remanente Induktion des Magnetfeldes von 0,03 T bis 0,1 T) auf, dass im eingeschwungenen Betriebszustand die Zerstäubung der Mosaiktargetfragmente proportional der aktiven Oberfläche ist und von ihren Zerstäubungskoeffizienten eigentlich nicht abhängt.

Die entwickelte Magnetronzerstäubungsvorrichtung enthält auch ein Paar Lichtbogen-Metallionenquellen mit Stabilisierungsspulen, mit denen das Ion-Atom-Verhältnis radikal geändert werden kann. Das Substrat kann in verschiedenen Phasen des Beschichtungsprozesses beschossen sowie die Ionendotierung der Oberflächenschichten der Erzeugnisse mit Metall und/oder Gas (z. B. Stickstoff) durchgeführt werden. Die Paarkopplung der ausgeglichenen und unausgeglichenen Magnetrone sowie der zwei dazwischen installierten Ionenquellen. Die zwei Lichtbogen-Metallionenquellen als Zerstäuber erzeugen das Magnetfeld, das eine effektive Haftstelle für die Elektronen bildet. Die Besonderheit der Magnetfelderzeugung der vorgeschlagenen Vorrichtung besteht darin, dass ungeachtet verschiedener Schaltungen der Magnetrone, der Ionen- und der Lichtbogenquellen im Beschichtungsprozess wenn:
a) nur unausgeglichene Magnetrone funktionieren,
b) nur Ionenquellen funktionieren,
c) nur Lichtbogenzerstäuber funktionieren,
d) unausgeglichene und ausgeglichene Magnetrone zusammen funktionieren, alle oben genannten Vorrichtungen zusammen funktionieren, (d. h. in jeder beliebigen Ausführungsvariante der Betriebsarten der vorgeschlagenen Vorrichtung) erfolgt der Magnetfeldschluss und es wird eine effektive Haftstelle für Elektronen gebildet Diese Besonderheit der vorgeschlagenen Vorrichtung ermöglicht es, den Ionisationsgrad wesentlich zu steigern, die hohe Dichte der Entladungsleistung von 40 bis 500 W/cm² und eine remanente Induktion des Magnetfeldes von 0,03 T bis 0,1 T im Bereich der Höchsterosion der Targetsoberfläche zu erreichen.

Die Erfindung wird anhand eines in den Zeichnungen schematisch dargestellten Ausführungsbeispiels näher erläutert. Es zeigen:
- Fig. 1: einen Querschnitt durch die Bezeichnungsvorrichtung und
- Fig. 2: einen Teil des Querschnitts des ausgeglichenen, gekühlten Hoch- geschwindigkeitsmagnetrons.

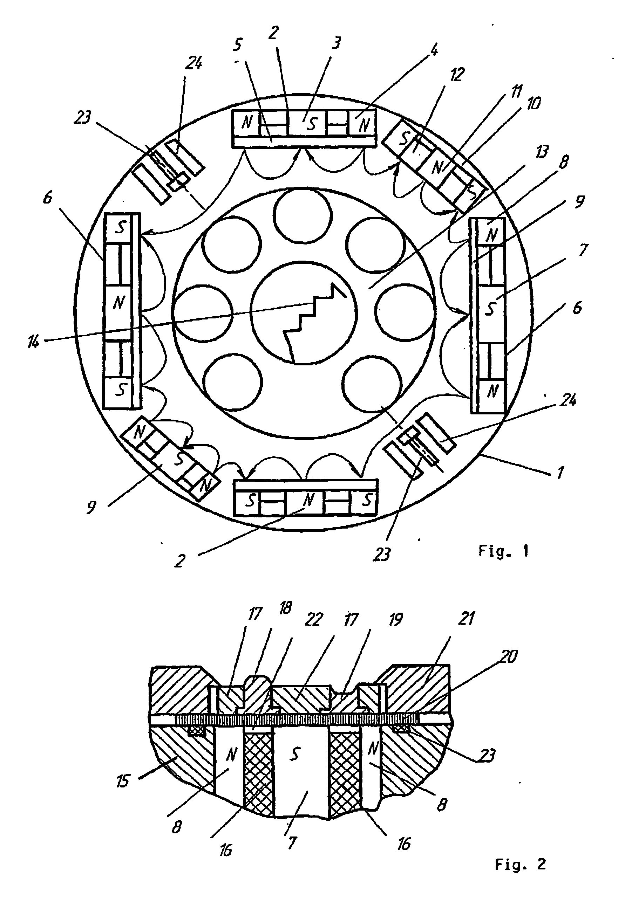

In Fig. 1 ist der Querschnitt der erfindungsgemäßen Beschichtungsvorrichtung mit dem Anordnungsplan der ausgeglichenen und unausgeglichenen Magnetrone, der Ionenquellen, der Lichtbeenquellen, des Erhitzers und der Planeten-Karusselleinrichtung zur Anordnung der Erzeugnisse dargestellt.

In einer dichten Kammer 1 (s. Fig. 1) sind zwei unausgeglichene Magnetrone 2 mit Innen- 3 und Außen- 4 -Ringmagnetpolen einander gegenüber angeordnet. An der Innenobefläche der Magnetrone 2 sind die aus einem homogenen Material hergestellten Targete befestigt. In der Kammer 1 sind auch zwei ausgeglichene gekühlte Hochgeschwindigkeitsmagnetrone 6 mit Innen- 7 und Außen- 8 -Ringmagnetpolen einander gegenüber angeordnet. An der Innenoberfläche der Magnetrone 6 sind die Mosaiktargete 9 befestigt. In den Zwischenräumen zwischen zwei Paaren der unausgeglichenen Magnetrone 2 und der ausgeglichenen Hochgeschwindigkeitsmagnetrone 6, die sich zwischen ihren gleichgepolten Außenringmagnetpolen 4 und 8 befinden, sind zwei gegenüber einander installierte Ionenquellen 10 mit Kaltkathode angeordnet. Die Ionenquellen 10 sind als gegenläufig gerichtete Innen- 11 und Außen- 12 -Ringmagnetpole ausgeführt, wobei der Außenpol-Ringmagnetpole 12 jeder Ionenquelle und die Außenringmagnetpole 4 und 8 der nächstliegenden unausgeglichenen und ausgeglichenen Magnetrone 2 und 6 gegengepolt sind. In zwei anderen Zwischenräumen zwischen zwei Paaren der unausgeglichenen Magnetrone 2 und der ausgeglichenen Hochgeschwindigkeitsmagnetrone 6 sind zwei Lichtbogen-Metallionenquellen 23 mit Stabilisierungsspulen 24 angeordnet. In der Mitte der Kammer 1 ist eine Planeten-Karusselleinrichtung 13 zur Befestigung der zu beschichtenden Erzeugnisse angeordnet. Die Erzeugnisse sind elektrisch ans negative Potential angeschlossen, um positive Ionen anzuziehen. In der Planeten-Karusselleinrichtung 13 ist der Erhitzer 14 zur Erhitzung der Erzeugnisse bis zu einer Temperatur von 1200 °C angeordnet.

Im wassergekühlten Hohlraum der Kathode 15 (s. Fig. 2) ist ein ausgeglichenes Magnetsystem angeordnet, das in Form eines ausgeglichenen Hochgeschwindigkeitsmagnetrons ausgeführt ist. Das Hochgeschwindigkeitsmagnetron 6 ist mit InnenRingmagnetpole 7 und Außen-Ringmagnetpole 8 ausgeführt, die durch das aus einem nichtmagnetischen Material hergestellte Distanzstück 16 voneinander getrennt sind. Das Mosaiktarget ist als ein Satz von drei Typen der verschiedene Zerstäubungskoeffiziente aufweisenden Einsätze 17, 18 und 19 ausgeführt. Die Targeteinsätze sind auf der Dünnplatte 20 aus hochwärmeleitfähigem Material installiert und an diese Platte angedrückt. Über Dichtungen 23 sind die Targeteinsätze an das Gehäuse 15 mit dem Stück 21 gedrückt. Zwischen der Rückseite der Platte 20 und den Magnetronstimseiten sind in der Breite des 10 - 20 mm-Distanzstücks 16 die Spalte 22 mit einer Dicke von 4 bis 6 mm hergestellt. Die Spalte 22 bilden den Kanal zum Durchfluss der Kühlflüssigkeit und sind mit dem System zur Kühlmittelzufuhr- und -abfuhr verbunden. Die Breite des Innenhohlraums im Gehäuse 15 zur Anordnung der gekühlten Kathodenbaugruppe beträgt von 50 bis 85 mm.

Das vorgeschlagene Verfahren und das Funktionsprinzip der Vorrichtung werden im Folgenden anhand von Ausführungsbeispielen zum Abscheiden von verschiedenen dicken Schichten näher beschrieben.

### Beispiel 1

Es wurde ein nanostrukturierter Mehrkomponenten-Mehrschicht- Überzug von Kohlenstoff, Niobium, Nickel auf ein Substrat aus Stahl IIIX-15 abgeschieden. Der Überzug wurde auf dem IIIX-15-Stahl -Stab vom 12 mm Durchmesser und 150 mm Länge hergestellt. Der Überzug wurde zur Erreichung eines Festschmierstoff-Effekts und zur Sicherung der Verschleißfestigkeit der Reibpaare inklusive der Gleit- und Wälzlager verwendet.

Zur Beschichtung wurde die Vorrichtung nach Anspruch 1 angewandt. Die Vorrichtung enthält zwei unausgeglichene Magnetrone 2 mit monolithischen Targeten von 350 x 145 x 10 mm. Das eine Target ist aus Chrom BX-1, das andere - aus Graphit M 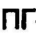 -7 hergestellt. Das Chrom wurde als Schichtunterlage unter der Hauptschicht zur Adhäsion und der Graphit als ein der Festschmierstoffschicht angehörendes Hauptmaterial angewandt.

Die Festschmierstoff-Hauptschicht aus Kohlenstoff und Niobium im Verhältnis: C = 95 Atomprozent und Nb = 5 Atomprozent wurde anhand von zwei Magnetronen 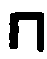 K-350 (6) mit ausgeglichenen Magnetsystemen mit einer remanenten Induktion des Magnetfeldes von 0,065 T, mit 12 Mosaiktargeten von 350 x 100 x 10 mm aus Graphit mit Niobeinsätzen vom 12 mm Durchmesser abgeschieden. Die Mosaiktargete wurden gleichmäßig entlang der Achsenlinie des Bereiches der Höchsterosion der Kathode angeordnet. Die aktive Oberfläche der Niobeinsätze betrug 5 % von der Gesamtfläche des Mosaiktargets im Bereich seiner Höchsterosion. Das Mosaiktarget wurde einer Vorzerstäubung im Betriebszustand unterzogen. Der Abstand zwischen der Oberfläche des Erzeugnisses und den Kathoden der ausgeglichenen Magnetrone 6 war bei der Beschichtung 50 mm.

Zum Abscheiden der Nickelschicht (die einzelne Monoschichten trennt, die die Festschmierstoff-Hauptschicht aus Kohlenstoff und Niobium bilden) wurden 2 Lichtbogenzerstäuber 23 mit Kathoden aus Nickel H-1 angewandt. Der Abstand zwischen der Oberfläche des Erzeugnisses und den Kathoden des Lichtbogenverdampfers 23 war 250 mm.

Zur Reinigung der Oberfläche des Erzeugnisses wurden 2 Ionenquellen 10 mit Kaltkathode mit einer Arbeitszone von 350 mm und ein Erhitzer 14 zur Erhitzung der Erzeugnisse bis zu Temperaturen von 350 °C angewandt.

Das Abscheiden des Mehrschichtüberzugs erfolgte nach folgendem Schema und Betrieb:

Die Stab-Erzeugnisse wurden in Kassetten an den drehbaren Tischpositionen auf dem Planetentisch 13 des Karussells angeordnet. Die Arbeitskammer 1 wurde bis zu einem Druck von 2,6 - 3,9 10⁻⁴ Pa evakuiert. An den Karusselltisch 23 mit den Erzeugnissen wurde das negative Verschiebungspotential von -900 V angelegt und die Drehung eingeschaltet

Dann wurde die Ionenquelle 10 mit folgenden Betriebsparametern eingeschaltet: Vakuum 0,06 - 0,08 Pa, Gas - Argon, Dichte des lonenstromes - 15 mA/cm2, Zeit - 10 Minuten. Während der Arbeit der Ionenquelle 10 wurde der Erhitzer 14 eingeschaltet, und die Temperatur bis auf 350 °C gesteigert. Das Heizelement - Band aus nichtrostendem Stahl hat 0,3 mm Dicke. Die Heiztemperatur des Bandes: 800 ± 50 °C und die Erhitzungszeit: 20 Minuten.

Zum Abscheiden der Chrom-Schichtunterlage mit 0,3 bis 0,5 µm Dicke, wurden zwei unausgeglichene Magnetrone 2 gleichzeitig eingeschaltet und der Argondruck in der Arbeitskammer 1 wurde bis zu 0,1 - 0,12 Pa gesteigert. Folgender Betrieb der Magnetrone 1 wurde angewandt: Entladungsleistungsdichte: 10 - 15 W/cm², Stromdichte: 18 - 27 mA/cm², Verschiebungspotential am Substrat: 40 V, Arbeitszeit: 20 Minuten.

Dann wurde das Magnetron 2 mit dem Chrom-Target ausgeschaltet, der Druck bis auf 0,26 - 0,4 Pa gesteigert und zwei ausgeglichene Magnetrone 6 nK-350 zum Abscheiden der Hauptschicht mit einer Gesamtdicke von 9,5 µm eingeschaltet.

Dabei wurde folgender Betrieb der Magnetrone 6 angewandt: Entladungsleistungsdichte: 60 - 70 W/cm², Stromdichte: 120 - 140 mA/cm2, Verschiebungspotential: 40 V, Arbeitszeit: 90 Minuten.

Beim Abscheiden der Hauptschicht aus Kohlenstoff - Niobium wurden intermittierend (jede 3 Minuten) 2 Lichtbogenzerstäuber 23 eingeschaltet Die Gesamtzeit der Arbeit der Lichtbogenzerstäuber 23 war 9,3 Minuten in 28 Einschaltzyklen, bei einem Strom von 70 A. Die Gesamtdicke der Nickelschicht war 2,5 µm.

Auf der Oberfläche des Erzeugnisses wurde also eine Festschmierstoffschicht mit Atomzusammensetzung von 95 % C und 5 % Nb hergestellt.

Die Qualität der abgeschiedenen Schicht wurde nach folgenden Standardvorschriften geprüft:

Die Schichtdicke wurde am Testmuster nach dem "Kugel-Schliff"-Verfahren vorgemessen. Dazu wurde am Testmuster, d. h. an der Scheibe Ø 30 mm und 3 mm dick, ein Schliff - Krater hergestellt. In der Schicht wurde ein Krater mit der 0 30 mm-Kugel ausgerieben und die Schichtdicke mit dem Lichtmikroskop MMy-3 gemessen.

Wiederholt wurde die Dicke bei der Prüfung der Zusammensetzung und der Struktur mit dem Rasterelektronenmikroskop (REM) XL-30 PHILIPS mit Röntgenmikroanalysator und Energiedispersionsdetektor Sapphire geprüft.

Dazu wurde ein Testmuster in Form einer Platte 20 x 5 x 3 mm verwendet, die im Winkel von 180° vorgebogen wurde. Die Messung wurde an der Biegungs- und Rissbildungsstelle durchgeführt.

Anhand eines Testmusters - einer Scheibe (die Oberfläche wurde vor Beschichtung bis zu Rauhigkeit von 0,3 - 0,5 µm poliert) - wurde die Adhäsion nach dem "Scratch-test" Verfahren gemessen. Als Prüfkörper wurde eine Diamantpyramide verwendet Der Belastungsbereich war 10 bis 80 N. Der entdeckte Bruchtyp war der Adhäsionstyp, bei maximaler Last von 80 N.

Die Hauptcharakteristiken der Schicht - der Gleitreibungskoeffizient und die Verschleißfestigkeit - wurden am "PIN ON DISK TEST"- Prüfstand bei einer Last von 10, 20, 40 und 80 N geprüft und getestet. Dazu wurde ein Testmuster - eine Scheibe Ø 30 mm und 3 mm dick verwendet, deren eine Seite mit der zu prüfenden Schicht beschichtet wurde. Als Verschleißprülkörper wurde eine Kugel 0 5 mm aus Stahl 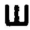 X-15 verwendet. Der festgestellte Reibungskoeffizient war 0,15 bei einer Last von 80 N. Der Verschleiß war 2.10⁻¹⁷m³/mN (ohne Schicht beträgt der Stahl-Stahl-Reibungskoeffizient 0,8 - 0,9 und der Verschleiß ist 6.10⁻¹³m³/mN).

### Beispiel 2

Es wurde ein Mosaiktarget zur Abscheidung von Dreikomponentenfilmschichten aus Kupfer, Zirkon und Kohlenstoff mit Anteilen von 50, 25 bzw. 25 Atomprozent hergestellt. Dieser Überzug weist einen niedrigen Reibungskoeffizient (weniger als 0,3) und die den Eigenschaften vom Konstruktionsstahl nahegelegenen mechanischen Eigenschaften auf. Als Targetsmaterial wurde eine Kupferplatte mit einer Erosionszonenfläche von 108 cm² verwendet. Auf dieser Fläche wurden in Durchgangslöchern im Target 28 zylindrische Einsätze mit 16 mm-Durchmesser, d. h. 14 Einsätze aus Zirkon und 14 Einsätze aus Graphit, angeordnet. Der Abstand zwischen den Nachbareinsätzen aus Zirkon und Graphit war 20 mm, und der Abstand zwischen gleichartigen Einsätzen war daher 40 mm. Auf das Target mit den Einsätzen wurde rückflächenseitig im Vakuum eine Schicht für Löten aufgetragen, die aus der Titan-Adhäsionsschicht und der Kupfer-Hauptschicht bestand. Die Titanschicht wurde zur Verbesserung der Adhäsion zwischen der Kupferschicht und den Kohlenstoffeinsätzen verwendet. Diese Schicht war 2 bis 5 µm dick. Die Dicke der Kupferschicht für Löten war 10 bis 15 µm. Nach dem Aufbringen der Schichten wurde diese Oberfläche mit Weißlot verzinnt. Das Target wurde an die Kupferunterlage angelötet. Die Grundlage war ein Kupferblech mit 0,2 mm Dicke. Das Mosaiktarget wurde im wassergekühlten Kathodengehäuse des Magnetrons über dem Magnetsystem angeordnet. Dann wurde die Endoperation zur Herstellung des Targets durch Vorzerstäubung im Betriebszustand durchgeführt. Die Vorzerstäubung des Targets erfolgte im ausgeglichenen Magnetronsystem mit folgenden Parametern: remanente Induktion des Magnetfeldes = 0,035 T; Arbeitsdruck des Argons = 0,5 Pa; Magnetron-Entladungsleistungsdichte = 28 W/cm²; Zerstäubungsspannung = 540 V; Entladungsstrom = 5,6 A, Zerstäubungszeit = 25 Minuten. Die Zerstäubungskoeffzienten vom Kupfer, Zirkon und Graphit bei einer Entladungsspannung von 500 bis 600 V betragen 2,1; 0,85 bzw. 0,24. Die Prüfung des hergestellten Targets mittels einer Mikrometerprobe hat gezeigt, dass die Arbeitsflächen des Targets aus Kupfer und der Einsätze aus Zirkon die Arbeitsfläche der Einsätze aus Graphit um 0,1 bzw. 0,04 mm übertrafen.

Die Analyse der Schichten, die bei Anwendung des Mosaiktargets nach seiner Vorzerstäubung hergestellt wurden, zeigte, dass die Zusammensetzung der hergestellten Schichten in Atomprozenten ungefähr dem Gehalt von 50 % Kupfer, 25 % Zirkon und 25 % Kohlenstoff entspricht. D. h. der Gehalt der Komponenten in der Schicht entsprach der Oberfläche seiner Fragmente im Bereich der Höchsterosion des Targets.

### Beispiel 3

Es wurde eine hitzebeständig Mehrkomponentenschicht aus Wolfram-MolybdänLegierung mit einem in der Schichtdicke variablen Wolframgehalt, bis zu 20 µm Dicke, auf das Molybdänsubstrat anhand des Mosaiktargets abgeschieden. Zweck der Beschichtung war, die Hitzebeständigkeit des Molybdäntiegels im Kontakt mit einer Aluminiumoxidschmelze bei einer Temperatur von ca. 2100 °C und einer längeren Verweilzeit über 35 Stunden zu sichern.

Zur Beschichtung wurde die Vorrichtung nach den Ansprüchen 1, 2 und 3 angewandt. Die Beschichtung wurde folgenderweise durchgeführt. Zur Adhäsion und Herstellung der Übergangsschicht wurde am ersten unausgeglichenen Magnetron 2 ein Molybdäntarget, und am zweiten unausgeglichenen Magnetron 2 ein Wolframtarget installiert. Das Abscheiden der Hauptschicht wurde mittels der ausgeglichenen Magnetrone 6 durchgeführt, die mit Mosaiktargeten aus Wolfram und Molybdän mit einem Flächenverhältnis der Arbeitsoberflächen der Komponenten von 80 : 20 ausgestattet sind. Die Reinwolfram-Oberflächenschicht wurde mittels 2 Lichtbogenverdampfer 23 aufgetragen.

Die Aktivierung und die Erhitzung des Molybdänsubstrats wurde mittels der Ionenquellen 10, des Erhitzers 14 und der Lichtbogenverdampfer 23 durchgeführt. Der Prozess wurde in folgenden Betriebsarten durchgeführt:

Die Erzeugnisse in Form der Molybdäntiegel wurden am Karussell 13 mit der den Ionenquellen 10 zugewandten Arbeitsoberfläche, in einer Entfernung von 100 mm angeordnet. Dabei war die Distanz von den unausgeglichenen Magnetronen 2 - 70 mm, von den ausgeglichenen Magnetronen 6 - 20 mm und von den Lichtbogenquellen 23 -150 mm.

Die Arbeitskammer 1 wurde bis zu einem Restdruck von 6,6 10⁻⁴ Pa evakuiert. Dann wurden die Erzeugnisse bis zu einer Temperatur 850 °C erhitzt und der Druck bis 0,10 - 0,12 Pa gesteigert. Das Argongas wurde in die Kammer 1 eingelassen und die Ionenquelle 10 bei einer Stromdichte von 30 mA/cm² und beim Verschiebungspotential zuerst (innerhalb von 10 Min.) bis 900 V eingeschaltet. Dann wurde das Verschiebungspotential bis auf 40 V verringert, die Ionenquellen 10 abgeschaltet und die Übergangsschicht mit 1 µm Dicke, im Laufe von 30 Min. bei einer Leistungsdichte von 30 W/cm² und einer Stromdichte von 50 mA/cm² aufgetragen. Dann wurden zwei ausgeglichene Magnetrone 6 mit Mosaiktargeten mit einem Flächenverhältnis der Arbeitsoberflächen der Komponenten (Wolfram und Molybdän) von 50 : 50 wieder eingeschaltet. Innerhalb von 30 Minuten wurde die Schicht mit 6,0 µm Dicke mit einer Leistungsdichte von 80 W/cm², einer remanenter Induktion des Magnetfeldes = 0,095 T und einer Stromdichte von 150 mA/cm² aufgetragen. Dann wurden die unausgeglichenen 2 und ausgeglichenen 6 Magnetrone ausgeschaltet und die ausgeglichenen Magnetrone 6 mit Targeten mit einem Flächenverhältnis der Arbeitsoberflächen der Komponenten (Wolfram und Molybdän) von 80 : 20 eingeschaltet. Im Laufe von 40 Minuten wurde die Schicht mit 10 µm Dicke mit einer Leistungsdichte von 150 W/cm² und einer Stromdichte von 300 mA/cm² aufgetragen. Dann wurden die Magnetrone 2 und 6 ausgeschaltet und die Lichtbogenverdampfer 23 mit einem Strom von 180 A eingeschaltet. Dabei wurde die Reinwolfram-Oberflächenschicht mit 8 µm Dicke aufgetragen.

Die Prüfung der Tiegel mit einem solchem Überzug zeigte, dass die Hitzebeständigkeit ohne Abblätterung gesichert, der Gasausgang aus dem Substrat gesperrt und die Verträglichkeit der Aluminiumoxidschmelze mit dem Tiegelmaterial bei einer Temperatur bis ca. 2100 °C im Laufe der Schmelzung von 35 Stunden gesichert ist.

### Beispiel 4

Das Berylliumoxid-Keramiksubstrat (Isolator) wurde mit einer Dreikomponentenschicht Niob- Molybdän- Nickel beschichtet.

Zur Hartlötung (Lötmaterial 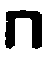 CP-72) des Keramiksubstrats an die Wärmeabführungsgrundlage aus Metall wurden wärmeabführende Dreikomponenten-Adhäsionsschichten Niob- Molybdän- Nickel von einer Gesamtdicke bis 15 µm Dicke hergestellt. Eine solche Schicht ersetzt eine Dickfilmschicht auf der Grundlage der Molybdän-Glasphase, die eine niedrige Wärmeleitfähigkeit und eine unstabile Adhäsion aufweist.

Die Vorrichtung enthielt alle Bestandteile nach den Ansprüchen 1, 2, 3: Ionenquellen 10 zur Voraktivierung, unausgeglichene Magnetrone 2 zum Abscheiden von Niob-Adhäsionsschichten mit 1,5 - 2,0 µm Dicke, ausgeglichene Magnetrone 6 zum Hochgeschwindigkeitsabscheiden der Molybdän-Konstruktionsschicht mit 10 - 12 µm Dicke, Lichtbogenverdampfer 23 zum Abscheiden der Nickelschicht für Löten mit 3 - 4 µm Dicke, Erhitzer 14 zur Haltung der Aktivierungstemperatur bis zu 850 °C. Beim Abscheiden der Schicht wurden folgende Reihenfolge und Betriebe der Vorrichtungen eingestellt: Die Ionenquelle 10 wurde in einer Entfernung von 100 mm von der zu beschichtenden Oberfläche angeordnet und innerhalb der ersten 10 Minuten des Prozesses bei einer Ionenstromdichte von 30 mA/cm² und einem Argondruck von 0,1 - 0,12 Pa eingeschaltet. Der Erhitzer 14 wurde von Beginn des Prozesses zur Erhitzung der Erzeugnisse bis zu 850 °C eingeschaltet und nach Beendigung des Nickelabscheidens ausgeschaltet. Zum Abscheiden der Schicht mit 1,5 µm Dicke wurden die unausgeglichenen Magnetrone 2 für 20 Minuten-Arbeit nach 10 Minuten-Aktivierung und Erhitzung der Oberfläche der Erzeugnisse, bei einer Entladungsleistungsdichte von 40 W/cm², einer 50 mm-Distanz von der Oberfläche des Erzeugnisses und einem Argondruck von 0.26-0.4 Pa eingeschaltet. Zum Abscheiden der Schicht mit 12 µm Dicke wurden die ausgeglichenen Magnetrone 6 mit remanenter Induktion des Magnetfeldes von 0,099 T für 60 Minuten-Arbeit nach dem Abscheiden der Niobschicht mit einer 30 mm-Distanz von der Oberfläche des Erzeugnisses und einem Argondruck von 0.26-0.4 Pa eingeschaltet. Zum Abscheiden der Nickelschicht mit 3,5 µm Dicke wurden die Lichtbogenverdampfer 23 auf Endetappe des Prozesses für 30 Minuten bei einem Argondruck von 0,1 - 0,12 Pa und einem Strom von 70 A eingeschaltet. Die Erzeugnisse wurden auf die Schicht-Keramik-Haftfestigkeit geprüft. Die Prüfungen wurden mit der Reißmaschine "Instron" durchgeführt und zeigten, dass der Wert σB 6kg/mm² beträgt Das Abreißenverhalten der Schicht entsprach der Festigkeitsgrenze der Keramik nach den Charakteristiken der Keramikzerstörung. Die Schicht-Keramik-Adhäsion entsprach den Zugfestigkeitswerten für Keramik.

### Beispiel 5

Es wurde ein Mosaiktarget zur Abscheidung von Dreikomponentenfilmschichten aus Kupfer, Zirkon und Kohlenstoff mit Anteilen von 50, 25 bzw. 25 Atomprozent hergestellt. Dieser Überzug weist einen niedrigen Reibungskoeffizient (weniger als 0,3) und die den Eigenschaften vom Konstruktionsstahl nahegelegenen mechanischen Eigenschaften auf.

Als Targetsmaterial wurde eine Kupferplatte 300 x 70 x 10 mm mit einer Erosionszonenfläche von 108 cm² verwendet. Auf dieser Fläche wurden in Durchgangslöchern im Target 28 zylindrische Einsätze mit 16 mm-Durchmesser, d. h. 14 Einsätze aus Zirkon und 14 Einsätze aus Graphit, mit einem Schritt von 20 mm zwischen den Nachbareinsätzen aus Zirkon und Graphit, und mit einem Schritt ca. 40 mm zwischen den gleichartigen Einsätzen angeordnet. Auf das Target mit den Einsätzen wurde rückflächenseitig im Vakuum eine Schicht für Löten aufgetragen, die aus einer Titan-Adhäsionsschicht und einer Kupfer-Hauptschicht bestand. Die Titanschicht wurde zur Verbesserung der Adhäsion zwischen der Kupferschicht und den Kohlenstoffeinsätzen verwendet. Diese Schicht war 2 bis 5 µm dick. Die Dicke der Kupferschicht für Löten war 10 bis 15 µm. Nach dem Aufbringen der Schichten wurde diese Oberfläche mit Weißlot verzinnt, und das Target wurde an die Kupferunterlage angelötet. Die Grundlage war ein Kupferblech mit 0,2 mm Dicke. Der Querschnitt des Targets in dieser Ausführung ist in. Fig. 2 dargestellt.

Das Mosaiktarget auf der Unterlage wurde im wassergekühlten Kathodengehäuse des Magnetrons über dem Magnetsystem angeordnet. Dann wurde die Endoperation zur Herstellung des Targets durch die Vorzerstäubung im Betriebszustand durchgeführt. Die Zerstäubung des Targets erfolgte im ausgeglichenen Magnetronsystem 6 mit folgenden Parametern: remanente Induktion des Magnetfeldes = 0,035 T; Arbeitsdruck des Argons = 0,5 Pa; Magnetron-Entladungsleistungsdichte = 28 W/cm²; Zerstäubungsspannung = 540 V; Entladungsstrom = 5,6 A, Zerstäubungszeit = 25 Minuten. Die Zerstäubungskoeffizienten von Kupfer, Zirkon und Graphit bei einer Entladungsspannung von 500 bis 600 V betragen 2,1; 0,85 bzw. 0,24. Die Prüfung des hergestellten Targets mittels Mikrometerprobe hat gezeigt, dass die Arbeitsflächen des Targets aus Kupfer und der Einsätze aus Zirkon um 0,1 bzw. 0,04 mm tiefer als die Arbeitsfläche der Einsätze aus Graphit waren.

Auf den Substraten wurde die Schicht mit einer mittleren Dicke von 25 µm hergestellt. Es wurde die Phasenzusammensetzung der Schicht, ihre Mikrohärte und der Reibungskoeffizient bei verschiedenen Belastungen geprüft. Die Phasenzusammensetzung der Schicht wurde mit einem Röntgendiffraktometer 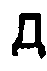 POII-4 nach der Methode des gleitenden Strahls im Winkel von 7 Grad und Bragg-Brentano- Fokussierung geprüft.

Die Messwertverarbeitung wurde mit den Programmen OUTSET, PHAN und PHAN% durchgeführt. Zur Bestimmung der Phasen wurde die Kartei ASTM angewandt. Die Elementenzusammensetzung wurde mit dem Rastermikroskop SEM-JETL mit einem Mikroanalysator und einem automatischem Messwertverarbeitungssystem LINK SYSTEMS geprüft. Die Mikrohärte wurde mit dem Mikrohärteprüfer FISCHERSCOPE H 100 mit einer Last von 50 mN geprüft. Der Gleitreibungskoeffizient wurde nach dem Verfahren "PIN ON DISK TEST" an den beschichteten Mustern in Form der Ø 30mm-Scheiben geprüft. Als Verschleißprüfkörper wurde eine Kugel 0 5 mm aus Stahl 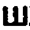 X-15 verwendet, wobei die Belastung der Kugel 10, 20, 40 und 80 N war.

### Beispiel 6

Es wurde ein Überzug aus nichtrostendem Stahl vom Typ 18 -10, 20 - 25 µm dick, auf ein Substrat aus unlegiertem Stahl C_{T}-3 abgeschieden. Zur Sicherung der Korrosionsbeständigkeit in der Atmosphäre einer Industriestadt wurden die Erzeugnisse - Stäbe 15 mm Durchmesser und 300 mm Länge, aus Stahl C_{T}-3 - mit einem nichtrostendem Austenit-Stahl OX18111OT beschichtet.

Zur Beschichtung wurde die Vorrichtung nach Anspruch 1 angewandt, die in Fig. 1 dargestellt ist.

Die Vorrichtung enthielt zwei unausgeglichene Magnetrone 2 mit monolithischen Targeten von 350 x 145 x 10 mm, aus Titan BTI-00. Titan wurde als Schichtunterlage unter der Hauptschicht zur Adhäsion der dicken Schichten aus nichtrostendem Stahl mit mehr als 5 µm Dicke angewandt. Der Abstand zwischen den Magnetronkathoden war 80 mm. Die Hauptschicht aus nichtrostendem Stahl wurde anhand von zwei ausgeglichenen Magnetrone 6 nK-350 mit monolithischen Targeten von 350 x 145 x 10 mm aus nichtrostendem Stahl abgeschieden. Der Beschichtungsabstand war 30 mm. Zur Reinigung der Oberfläche der Erzeugnisse und der Aktivierung wurden in der Vorrichtung 2 Ionenquellen 10 mit einer Kaltkathode mit einer Arbeitszone von 350 mm, ein Erhitzer 14 zur Erhitzung der Erzeugnisse bis zu einer Temperatur von 750 °C und zwei Lichtbogenquellen 23 mit dem Durchmesser der Behandlungszone von 300 mm angewandt. Die Kathoden waren Titankathoden BTI-00. Der Abstand zwischen der Oberfläche der Erzeugnisse und den Ionen- und Lichtbogenquellen 10 und 23 war 100 bzw. 200 mm. Die Beschichtung erfolgte im folgenden technologischen Betrieb:

Zuerst wurden die Ionenquellen 10 eingeschaltet, und das negative Verschiebungspotential von - 900 V wurde an das Karussell 13 angelegt. Dabei wurden folgende Betriebsparameter eingestellt: Vakuum 0,06 - 0,08 Pa, Gas - Argon, Dichte des Ionenstromes - 15 mA/cm2, Zeit - 10 Minuten. Dann wurde der Erhitzer 14 eingeschaltet, dessen Heizelement als ein Band aus Molybdän mit 0,3 mm Dicke ausgeführt ist. Die Erzeugnisse wurden innerhalb von 20 Minuten bis 780 ± 20 °C erhitzt. Während des Einschaltens des Erhitzers 14 wurde die Ionenquelle 10 gleichzeitig ausgeschaltet und der Argondruck in der Kammer 1 bis auf 0,1 - 0,12 Pa gesteigert, sowie zwei unausgeglichene Magnetrone 2 eingeschaltet. Dabei wurde folgender Betrieb der Magnetrone angewandt: Entladungsleistungsdichte: 10 -15 W/cm², Stromdichte: 18 - 27 mA/cm², Verschiebungspotential: 40 V, Arbeitszeit: 20 Minuten.

Nachdem zwei unausgeglichene Magnetrone 2 20 Minuten gearbeitet haben und die 0,3 -0,5 µm dicke Titan-Unterlage aufgetragen wurde, wurden zwei ausgeglichene Magnetrone 6 eingeschaltet und der Argondruck bis auf 0,26 - 0,4 Pa gesteigert.

Dabei wurde folgender Betrieb der Magnetrone eingestellt: Entladungsleistungsdichte: 90 - 100 W/cm², remanente Induktion des Magnetfeldes = 0,1 T; Stromdichte: 175 - 195 mA/cm², Verschiebungspotential: 40 V. Im Laufe der Arbeitszeit von 120 Minuten wurde eine 22 µm dicke Schicht abgeschieden.

Zwecks Erhöhung der Aufheizgeschwindigkeit und der Reduzierung der Prozesszeiten bei der Beschichtung von Massiverzeugnissen wurden zur intensiven Durchheizung und Aktivierung auf der ersten Etappe anstatt der zwei Ionenquellen 10 zuerst die Lichtbogenquellen 23 eingeschaltet und das Verschiebungspotential von 900 V wurde an das Karussell 13 angelegt. Dabei wurde folgende Betriebsart der Lichtbogenquellen 23 eingestellt: Vakuum 0,06 - 0,08 Pa, Gas - Argon, Lichtbogenentladungsstrom - 75 A, Arbeitszeit der Lichtbogenquellen - 5 Minuten. Dann wurde der Erhitzer 14 eingeschaltet und die Hauptschicht wie oben beschrieben abgeschieden.

Die Qualität der abgeschiedenen Schicht die Dicke, die Adhäsion, die Struktur und die Korrosionsbeständigkeit wurden nach Standardvorschriften geprüft. Die Schichtdicke wurde am metallographischen Schliff nach dem "Kugel-Schliff"-Verfahren geprüft. Dazu wurde ein Testmuster, d. h. eine Scheibe 0 30 mm und 3 mm dick aus demselben Material wie das Erzeugnis verwendet. In der Schicht wurde ein Krater mit der Kugel ausgerieben und die Schichtdicke wurde mit dem Lichtmikroskop MMY-3 gemessen. An demselben Testmuster wurde auch die Adhäsion nach dem "Scratch-test" Verfahren gemessen (d. h. Kratzen der Schicht mit einem Prüfkörper bei zunehmender Last). Als Prüfkörper wurde eine Stahlkugel verwendet. Der Belastungsbereich war 40 bis 350 N.

Die Zusammensetzung der Schicht wurde mit einem Rasterelektronenmikroskop (REM) XL-30 PHILIPS und einem Röntgenmikroanalysator mit Energiedispersionsdetektor Saphire geprüft. Die Korrosionstests wurden nach GOST 9.031-74 zur Prüfung der Korrosionsbeständigkeit von galvanischen Schichten mit einer Dicke ab 6 µm durchgeführt. Testmedium: pro 1 I Wasser: Na Cl (50 g) + CuCl₂ •2H₂O (0,3 g) + CH₂COOH (5 - 6 Tröpfe); Temperatur der Lösung: 40 ± 5 °C; Testzeit: 48 Stunden.

Testergebnise: folgende Schichtparameter sind erhalten: die Dicke der Unterlage 0,5 µm, die Dicke der Hauptschicht 21 µm, die Zusammensetzung der Schicht betr. Chrom, Nickel, Titan entspricht der Struktur OX18H10T in der γ-Phase. Die Schicht wird bei einer Belastung von 180 N ohne Abblätterung zerstört. Die Bruchart ist plastisch. Die Korrosionsbeständigkeit ist befriedigend und mit galvanischem Chrom vergleichbar. Die Anzahl der Defekte ist weniger als 0,1 % der Fläche.

Die in den Ausführungsbeispielen des Prozesses angeführten Ergebnisse zeigen, dass die hergestellten Mehrkomponentenschichten größerer Dicke gute Charakteristiken nach chemischer Zusammensetzung, Struktur und physikalisch-technischen Parametern aufweisen. Die Erzeugnisse mit solchen Deckschichten können breite Anwendung in verschiedenen Industrie-, Fach- und technischen Gebieten, z. B. in Maschinenbau, finden.

## Patentansprüche

1. Vorrichtung zum Ion-Plama-Abschelden von Mehrkomponentenfilmschichten mit einer geerdeten Kammer (1), einer in der Kammer (1) angeordnete Anodenvorrichtung, mit Mitteln zur Erzeugung eines elektrischen und eines magnetischen Feldes und mit einer In der Mitte der Kammer (1) angeordneten Planeten-Karusselleinrichtung (13) zur Befestigung der zu beschichtenden Erzeugnisse,
wobei,
die Mittel zur Erzeugung des Magnetfeldes zwei einander gegenüberliegend angeordnete unausgeglichene Magnetrone (2) enthält,
jedes unausgeglichene Magnetron (2) gegenläufig gerichteten Außenmagnetpole (4) und Innenmagnetpole (3) aufweist, wobei der Außenmagnetpol (4) des einen Magnetrons (2) und der Außenmagnetpol (4) des anderen Magnetrons (2) gegengepolt sind,
mindestens zwei ausgeglichene gekühlte Hochgeschwindigkeltsmagnetrone (6) vorgesehen sind, wobei Jedes ausgeglichene Hochgeschwindigkeitsmagnetron (6) gegenläufig gerichtete Außenringmagnetpole (8) und Innenringmagnetpole (7) aufweist und der Außenringmagnet (8) des einen Hochgeschwindigkeitsmagnetrons (6) und der Außenmagnetpol (8) des anderen Hochgeschwindigkeitsmagnetrons (6) gegengepolt sind,
in den Zwischenräumen zwischen zwei Paaren von unausgeglichenen Magnetronen (2) und ausgeglichenen Hochgeschwindlgkeitsmagnetronen (6) mit gleichgepolten Außenringmagnetpolen (4, 8) zwei gegenüberliegende installierte Ionenquellen (10) mit Kaltkathode angeordnet sind, die als gegenläufig gerichtete Innenringmagnetpole (11) und Außenringmagnetpole (12) ausgebildet sind, wobei der Außenringmagnetpol (12) jeder Ionenquelle (10) und die Außenpole der nächstliegenden unausgeglichenen Magnetrone (2) und ausgeglichenen Mochgeschwindlgkeitsmagnetrone (6) gegengepolt sind und
in zwei anderen Zwischenräumen zwischen zwei Paaren der unausgeglichenen Hochgeschwindigkeitsmagnetrone (6) und der ausgeglichenen Magnetrone (2), die sich zwischen Ihren gegengepolten Außenringmagnetpo-len (4, 7) befinden, zwei gegenüberliegende installierte Lichtbogen-Metallionenquellen (23) mit Stabilisierungsspulen angeordnet sind.

2. Vorrichtung nach Anspruch 1,
**dadurch gekennzeichnet,**
**dass** In der Mitte der Kammer (1) ein Erhitzer (14) zur Erhitzung der Erzeugnisse angeordnet ist.

3. Vorrichtung nach Anspruch 1 oder 2,
**dadurch gekennzeichnet,**
**dass** die ausgegilchenen Magnetrone (2) im gekühlten Hohlraum eines 50 bis 85 mm breiten Magnetrongehäuses (15) angeordnet sind und im Hohlraum ein Kanal in Form eines Spalts (22) zwischen dem Target und der Stirnseite eines Distanzstücks (16) zwischen den Magnetronpolen gebildet ist,
**dass** die Höhe des Spalts (22) zwischen 4 und 6 mm beträgt und
**dass** die Breite des Spalts (22) der Breite des Distantzstücks (16) entspicht und zwischen 10 und 20 mm beträgt.

4. Verfahren zum Ion-Plasma-Abscheiden von Mehrkomponentenfilmschichten unter Anwendung einer Vorrichtung nach Anspruch 1, wobei
zur Beschichtung folgende Operationen durchgeführt werden:
- Vorbereitung der unausgeglichenen Magnetrone (2) mit homogenen Targeten,
- Vorbereitung der ausgeglichenen Hochgeschwindigkeitsmagnetronen (6) mit Mosaiktargeten,
- Anordnung der Erzeugnisse in der Planeten-Karusseileinrichtung (13),
- Vorbereitung der Vorrichtung zur Arbeit,
- Ionenätzung und Aktivierung der Erzeugnisse mittels der unausgeglichenen Magnetrone (2) bei einer Dicke der Entladungsleistung von 5 bis 40 W/cm²,
- Nachaktivierung der Erzeugnisse mittels der Gasionen (z. B. Argonione) erzeugenden Ionenquelle (10) bei einer Beschleunigungsspannung bis 5000 V oder Aktivierung und Sättigung der Oberflächenschicht mit Metall oder Gas mittels der die Metall- oder Gasionen (z. B. Stickstoffione) erzeugenden Lichtbogenquelle (23) bei der Verschiebungsspannung am Erzeugnis von 1700 V,
- Erhitzung der Erzeugnisse durch den Erhitzer (14) bis zu einer Temperatur von 250 bis 1200 °C,
- Abscheiden der Primärschicht mittels der unausgeglichenen Magnetrone (2) bei der Dichte der Entladungsleistung von 5 bis 40 W/cm²,
- Abscheiden der Sekundärschichten bis zu einer Dicke von 10 µm durch gleichzeitige Anwendung der unausgeglichenen Magnetrone (2) bei der Dichte der Entladungsleistung von 5 bis 40 W/cm² und der ausgeglichenen Hochgeschwindigkeitsmagnetrone (6) bei der Dichte der Entladungsleistung von 40 bis 500 W/cm² und der remanenten Induktion des Magnetfeldes von 0,03 T bis 0,1 T,
- Abscheiden der Hauptschicht durch gleichzeitige Anwendung der unausgeglichenen Magnetrone (2) und der ausgeglichenen Hochgeschwindigkeitsmagnetrone (6) bei der Dichte der Entladungsleistung 40 bis 500 W/cm² und der remanenten Induktion des Magnetfeldes von 0,03 T bis 0,1 T und
- Abscheiden der Hauptschicht mit Mehrschicht-Nanokristallstruktur durch gleichzeitige Anwendung der unausgeglichenen Magnetrone (2) bei der Dichte der Entladungsleistung von 5 bis 40 W/cm² und der ausgeglichenen Hochgeschwindigkeitsmagnetrone (6) bei der Dichte der Entladungsleistung von 40 bis 500 W/cm² und der remanenten induktion des Magnetfeldes von 0,03 T bis 0,1 T, sowie der Lichtbogenquellen (23) mit dem Lichtbogenstrom von 40 bis 160 A und Spannung von 40 bis 80V.

5. Verfahren nach Anspruch 4,
**dadurch gekennzeichnet,**
**dass** die Erzeugnisse im Beschichtungsprozess mit Temperaturen von 250 bis 1200 °C erhizt werden, und
**dass** dann wird die Oberfläche der Erzeugnisse bei Temperaturen bis 1500 °C durch Beschuss mit Metall- und/oder Gasionen nacherhitzt werden, wobei die Gasionen mittels der Lichtbogenquellen (23) bei der Verschiebungsspannung am Erzeugnis von 1700 V erzeugt werden.

## Claims

1. A magnetron device for ion-plasma deposition of multicomponent film coatings comprising an earthed chamber (1) with an anode device installed in the chamber (1), with means for generation of electric and magnetic field and with a planetary carrousel mechanism (13) installed in the middle of the chamber (1) to hold articles to be coated,
wherein
said means for generation of electric and magnetic field contain two unbalanced magnetrons (2), installed opposite each other,
each of said unbalanced magnetrons (2) having an external ring magnetic pole (4) and an internal ring magnetic pole (3) oriented oppositely, and the external magnetic pole (4) of one magnetron (2) and the external magnetic pole (4) of the other magnetron (2) being oriented oppositely,
at least two cooled high-rate balanced magnetrons (6) are provided, each of said high-rate balanced magnetrons (6) having an external ring magnetic pole (8) and an internal ring magnetic pole (7) oriented oppositely, and the external ring magnetic pole (8) of one high-rate balanced magnetron (6) and the external ring magnetic pole (8) of the other high-rate balanced magnetron (6) being oriented oppositely,
two cold-cathode ion sources (10) are provided in the spaces between the two pairs of unbalanced magnetrons (2) and the high-rate balanced magnetrons (6), placed between their external ring magnetic poles (4, 8) of the same polarity, said two cold-cathode ion sources (10) being installed opposite each other and made as oppositely oriented ring magnetic poles: an internal ring magnetic pole (11) and an external ring magnetic pole (12), the external ring magnetic pole (12) of each ion source (10) having a polarity that is opposite to the polarity of the external poles of its neighboring unbalanced magnetrons (2) and high-rate balanced magnetrons (6), and
two arc sources (23) of metal ions are provided in two other spaces between the two pairs of high-rate balanced magnetrons (6) and unbalanced magnetrons (2) placed between their external ring magnetic poles (4, 7) of the opposite polarity, said two arc sources (23) of metal ions being installed opposite each other and equipped with stabilizing coils.

2. The device according to claim 1,
**characterized**
**in that** a heater (14) for heating articles is installed in the middle of the chamber (1).

3. The device according to claim 1 or 2,
**characterized**
**in that** the balanced magnetrons (2) are installed in a cooled cavity of a magnetron housing (15), 50 to 85 mm wide, the cavity being equipped with a channel made as a slit (22) between a target and an end face of a spacing insert (16) between the magnetron poles,
**in that** the height of the slit (22) is between 4 and 6 mm, and
**in that** the width of the slit (22) corresponds to the width of said spacing insert (16) and is between 10 and 20 mm.

4. A method for ion-plasma deposition of multicomponent film coatings using the device according to claim 1 is, wherein
the method including the following operations:
- preparation of the unbalanced magnetrons (2) with homogeneous targets,
- preparation of the high-rate balanced magnetrons (6) with mosaic targets,
- arrangement of articles in the planetary carrousel mechanism (13),
- preparation of the device to operation,
- ion etching and activation of articles using the unbalanced magnetrons (2) at the discharge power density of 5 to 40 W/cm²,
- additional activation of articles using the ion source (10) generating gas ions, e.g., argon ions, at an acceleration voltage of 5000 V or activation and saturation of the surface layer with metal or gas using the arc source (23) generating metal and gas ions, e.g., nitrogen ions, at the bias voltage at the article of 1700 V.
- heating the articles by the heater (14) up to a temperature of 250 to 1200°C;
- position of a primary coating layer using the unbalanced magnetrons (2) at a discharge power density of 5 to 40 W/cm²,
- deposition of secondary coating layers, up to 10 µm wide, by simultaneously using the unbalanced magnetrons (2) at a discharge power density of 5 to 40 W/cm² and the high-rate balanced magnetrons (6) at a discharge power density of 40 to 500 W/cm² and at a residual induction of magnetic field of 0.03 T to 0.1 T,
- deposition of a main coating layer by simultaneously using the unbalanced magnetrons (2) and the high-rate balanced magnetrons (6) at a discharge power density of 40 to 500 W/cm² and at a residual induction of magnetic field of 0.03 T to 0.1 T, and
- deposition of a main coating layer with a multilayer nanocrystalline structure by simultaneously using the unbalanced magnetrons (2) at a discharge power density of 5 to 40W/cm², the high-rate balanced magnetrons (6) at a discharge power density of 40 to 500 W/cm² and a residual induction of magnetic field of 0.03 T to 0.1 T, and the arc sources (23) at an are current of 40 to 160 A and voltage of 40 to 80 V.

5. The method according to claim 4,
**characterized**
**in that** the articles are heated during the deposition of multicomponent film coatings at a temperature of 250 to 1200°C, and
**in that** afterwards the surface of the articles is additionally heated up to 1500°C by ion bombardment thereof by metal and/or gas ions generated by the arc sources (23) at a bias potential of 1700 V at the article.

## Revendications

1. Système à magnétron pour le dépôt des revêtements pelliculeux multicomposant par une méthode de plasma ionique, comprenant une chambre à la terre (1) avec un dispositif anodique installée dans la chambre (1), avec des moyens destinés à créer un champ électrique et magnétique et avec un mécanisme à carrousel planétaire (13) installé au centre de la chambre(1) pour supportage des objets pulvérisés,
et avec cela
les moyens destinés à créer un champ électrique comprennent deux magnétrons déséquilibrées (2) disposés à l'opposite de l'un l'autre, chaque magnétron déséquilibré (2) a un pôle magnétique externe (4) et un pôle magnétique interne (3) repérés en sens contraires, et avec cela le pôle magnétique externe (4) d'un magnétron (2) et le pôle magnétique interne (3) du second magnétron (2) ont une polarité opposée,
on a prévoit au moins deux magnétrons équilibrés ultra-rapides réfrigérants (6), et en outre chaque magnétron équilibré ultra-rapide (6) a un pôle magnétique annulaire externe (8) et un pôle magnétique annulaire interne (7) repérés en sens contraires et un aimant annulaire externe (8) d'un magnétron ultra-rapide (6) et un aimant annulaire externe (8) du second magnétron ultra-rapide (6) ont la polarité opposée,
deux sources d ions (10) avec cathode froide, installées l'un contre l'autre, exécutés sous forme d'un pôle magnétique annulaire interne (11) et d'un pôle magnétique annulaire externe (12) repérés en sens contraires sont posées dans les interstices entre deux paires des magnétrons déséquilibrés (2) et des magnétrons équilibrés ultra-rapides (6) entre leur les pôles magnétiques annulaires externes (4, 8) avec polarité égale, et avec cela la pôle magnétique annulaire externe (12) de chaque source d'ions (10) et les pôles externes du magnétron déséquilibré (2) et du magnétron équilibré ultra-rapide (6) les plus proches de lui ont la polarité opposée et
deux sources arquées (23) d'ions métalliques avec des bobines de stabilisation installées l'un contre l'autre sont posées dans autre deux interstices entre deux paires des magnétrons déséquilibrés ultra-rapides (6) et des magnétrons équilibrés (2), qu'ils se trouvent entre leur pôles magnétiques annulaires externes (4, 7) aux polarités différentes.

2. Système selon la revendication 1,
**caractérisé en ce,**
**qu'**un réchauffeur (14) est installé au centre de la chambre (1) pour le chauffage des articles.

3. Système selon la revendication 1 ou la revendication 2,
**caractérisé en ce**
**que** les magnétrons équilibrés (2) sont disposés à la cavité refroidie de 50 à 85 mm de largeur de la boite (15) de magnétron et un canal est formé dans la cavité sous forme de la fente (22) entre la cible et la face terminale de l'insertion distancié (16) entre les pôles de magnétron,
**que** l'hauteur de la fente (22) est entre 4 et 6 mm,
**que** la largeur de la fente (22) est entre 10 et 20 mm et correspond à la largeur l'insertion distancié (16).

4. Le procédé du dépôt des revêtements pelliculeux multicomposant par la méthode de plasma ionique à l'aide du système selon la revendication 1
et avec cela pour le dépôt du revêtement on exécute des opérations suivantes :
- préparation des magnétrons déséquilibrés (2) comprenant les cibles homogènes,
- préparation des magnétrons équilibrés ultra-rapides (6) comprenant les cibles de mosaïque,
- emplacement des articles au mécanisme à carrousel planétaire (13),
- préparation du système à l'opération,
- décapage ionique et l'activation des articles à l'aide des magnétrons déséquilibrés (2) avec la puissance par unité de surface de la décharge de 5 à 40 W/cm²,
- activation complémentaire des articles à l'aide de la source d'ions (10), générée les ions du gaz (par exemple, de l'argon) avec la tension d'accélération jusqu'à 5000 V, ou l'activation et la saturation de métal ou de gaz de la couche superficielle à l'aide de la source arquée (23) générée des ions de métal ou des ions du gaz (par exemple, de l'azote) avec la polarisation sur l'article jusqu'à 1700 V,
- chauffage des articles par un réchauffeur à une température de 250 à 1200 °C,
- le dépôt du revêtement primaire à l'aide des magnétrons déséquilibrés (2) avec la puissance par unité de surface de la décharge de 5 à 40 W/cm²,
- le dépôt des couches de revêtement secondaire à l'épaisseur jusqu'à 10 µm comprenant l'application simultanée des magnétrons déséquilibrés (2) avec la puissance par unité de surface de la décharge de 5 à 40 W/cm² et des magnétrons équilibrés ultra-rapides (6) avec la puissance par unité de surface de la décharge de 40 à 500 W/cm² et rémanence magnétique de 0,03 T à 0,1 T,
- le dépôt des couches de revêtement basique comprenant l'application simultanée des magnétrons déséquilibrés (2) et des magnétrons équilibrés ultra-rapides (6) avec la puissance par unité de surface de la décharge de 40 à 500 W/cm² et rémanence magnétique de 0,03 T à 0,1 T et
- le dépôt des couches de revêtement basique à multicouche nanocristallin comprenant l'application simultanée des magnétrons déséquilibrés (2) avec la puissance par unité de surface de la décharge de 5 à 40 W/cm², des magnétrons équilibrés ultra-rapides (6) avec la puissance par unité de surface de la décharge de 40 à 500 W/cm² et rémanence magnétique de 0,03 T à 0,1 T, en outre des sources arquées (23) à un courant d'arc de 40 à 160 A et à une tension de 40 à 80 V.

5. Le procédé selon la revendication 4,
**caractérisé en ce**
**qu'**on chauffe les articles à une température de 250 à 1200 °C en cours du dépôt de revêtement et
**qu'**on chauffe complémentaire la surface des articles à une température jusqu'à 1500 °C grâce au bombardement des ions de métal et/ou des ions du gaz, générés par les sources arquées (23) avec la polarisation sur l'article jusqu'à 1700 V.
